Europäisches Patentamt

European Patent Office

Office européen des brevets

(11) Veröffentlichungsnummer: **0 314 013 B1**

(12) # EUROPÄISCHE PATENTSCHRIFT

(45) Veröffentlichungstag der Patentschrift:
14.08.91 Patentblatt 91/33

(51) Int. Cl.$^5$: **H03K 17/04**

(21) Anmeldenummer: **88117575.6**

(22) Anmeldetag: **21.10.88**

(54) **Verfahren zur Basisstromregelung eines Schalttransistors und Schaltungsanordnung zur Durchführung des Verfahrens.**

(30) Priorität: **26.10.87 DE 3736182**

(43) Veröffentlichungstag der Anmeldung:
**03.05.89 Patentblatt 89/18**

(45) Bekanntmachung des Hinweises auf die
Patenterteilung:
**14.08.91 Patentblatt 91/33**

(84) Benannte Vertragsstaaten:
**CH DE FR GB IT LI NL**

(56) Entgegenhaltungen:
**EP-A- 0 015 091**
**EP-A- 0 159 233**
**FR-A- 2 366 746**

(73) Patentinhaber: **Siemens Aktiengesellschaft**
**Wittelsbacherplatz 2**
**W-8000 München 2 (DE)**

(72) Erfinder: **Feldtkeller, Martin, Dipl.-Ing.**
**Josephsburgstrasse 59**
**W-8000 München 80 (DE)**

## Beschreibung

Die Erfindung betrifft ein Verfahren zur Basisstromregelung eines Schalttransistors, der zum Einschalten mit einem Basisstrom beaufschlagt und dessen Basiszone zum Ausschalten von Ladungsträgern ausgeräumt wird (Ausräumvorgang) sowie eine Schaltungsanordnung zur Durchführung des Verfahrens.

Werden Bipolartransistoren in periodischen Schaltsystemen, wie z.B. Schaltnetzteile, als elektronische Schalter, d.h. als Schalttranistoren, betrieben, so sollen diese im Idealfall folgende Merkmale aufweisen :

1. Hohe Schaltgeschwindigkeit,
2. geringer Ausgangswiderstand im eingeschalteten Zustand, und
3. sehr hoher Ausgangswiderstand im ausgeschalteten Zustand.

Es ist bekannt, daß Bipolartransistoren einen um so geringeren Ausgangswiderstand im eingeschalteten Zustand aufweisen, je stärker der Bipolartransistors beim Einschalten in die Sättigung gebracht wurde. Ein solcher Übersättigungsbetrieb hat jedoch den Nachteil, daß sich die maximale Schaltgeschwindigkeit, die insbesondere von der Speicherzeit des Bipolartransistros abhängig ist, vermindert. Unter Speicherzeit ist dabei die Zeit zu verstehen, während der der Schalttransistor noch leitet, ohne daß ein Basisstrom zur Aufrechterhaltung der Leitfähigkeit fließt. Die Speicherzeit läßt sich verkürzen, indem man den Basisstrom umkehrt, d.h. die Basiszone des Bipolartransistors von Ladungsträgern ausräumt. Bei starker Übersättigung kann der Transistor nicht durch einen entsprechend hohen Ausräumstrom beliebig schnell abgeschaltet werden, da sonst der Emitterstrom im Halbleiterkörper eingeschnürt wird und die Kollektor-Emitterspannung bereits ansteigt, während der Transistor seine Sperrfähigkeit noch nicht erlangt hat. Wird dagegen der Bipolartransistor mit zu geringem Basisstrom betrieben, so erhöhen sich dessen Durchlaßverluste.

Eine bekannte Schaltungsanordnung zur Reduzierung der Speicherzeit eines Bipolartransistors ist die sogenannte Baker-Klemm-Schaltung (Baker-clamp-circuit). Die Baker-Klemm-Schaltung ist z.B. in EDN, Oktober 27, 1983, Seite 265 bis 272 oder Machine Design, December 6, 1984 auf Seite 136 beschrieben. Diese bekannte Schaltungsanordnung stabilisiert die Kollektor-Emitter-sättigungsspannung. In der Regel enthält diese Schaltungsanordnung neben dem Bipolartransistor vier Dioden. Der Kollektoranschluß eines z.B. NPN-Bipolartransistors wird gemäß dieser bekannten Schaltungsanordnung mit dem Kathodenanschluß einer ersten Diode verbunden. Der Anodenanschluß dieser ersten Diode ist mit dem Kathodenanschluß einer zweiten Diode verbunden, deren Anodenanschluß an die Basis des NPN-Bipolartransistors geschaltet ist. Antiparallel zu dieser zweiten Diode ist die Serienschaltung von zwei, gegebenenfalls mehrerer gleichsinnig in Reihe liegender Dioden geschaltet. Der zum Ansteuern des NPN-Bipolartransistors nötige Basisstrom wird am Verbindungspunkt der ersten und zweiten Diode zugeführt. Die Baker-Klemm-Schaltung bewirkt, daß die Basis dieses NPN-Bipolartransistors nur einen solchen Steuerstrom erhält, daß die Kollektor-Emitter-Spannung ungefähr zwischen 1,2 und 1,6 V liegt. Der PN-Übergang zwischen Basis und Kollektor des NPN-Bipolartransistors bleibt rückwärts vorgespannt. Durch die Stabilisierung der Kollektor-Emitter-Sättigungsspannung wird die Speicherzeit des NPN-Bipolartransistors reduziert.

Diese Baker-Klemm-Schaltung hat den Nachteil, daß ihr Widerstand im eingeschalteten Zustand hoch ist.

Der Erfindung liegt deshalb die Aufgabe zugrunde, ein Verfahren zur Basisstromregelung von Schalttransistoren, insbesondere Bipolartransistoren, für periodischen Schaltbetrieb anzugeben, das unabhängig gegenüber Exemplarstreuung des verwendeten Schalttransistors stets quasi-Sättigungsbetrieb vorsieht. Unter quasi-Sättigungsbetrieb ist dabei zu verstehen, daß dem Schalttransistor gerade nur soviel Basisstrom zum Einschalten zugeführt wird, wie für ein optimales Schaltverhalten nötig ist.

Diese Aufgabe wird dadurch gelöst, daß beim Ausschalten des Schalttransistors das Basisstrom-Zeit-Integral (Ausräumladung) $Q_2$ als Maß für die Sättigung des Schalttransistors bestimmt wird, und daß abhängig von der Größe dieses Basisstrom-Zeit-Integrals (Ausräumladung) $Q_2$ der Basisstrom zum Einschalten des Schalttransistors eingestellt wird.

Weiterbildungen der Erfindung sind Gegenstand der Unteransprüche.

Eine Schaltungsanordnung zur Durchführung des Verfahrens ist dadurch gekennzeichnet, daß an die Basisklemme des Schalttransistors, in dessen Laststrecke die Reihenschaltung einer Last mit einer Spannungsquelle geschaltet ist, ein Koppelkondensator mit seinem einen Anschluß und eine Basisstromquelle mit ihrer Ausgangsklemme angeschlossen ist, daß eine Steuereinrichtung vorgesehen ist, durch die in den anderen Anschluß des Koppelkondensators Ströme positiver oder negativer Polarität einprägbar sind und durch die der Basisstrom am Ausgang der Basisstromquelle abhängig von der Ladung des Koppelkondensators einstellbar ist.

Die Erfindung wird im folgenden anhand von drei Figuren näher erläutert. Es zeichen :

FIG 1    ein Blockschaltbild zur Durchführung des Verfahrens mit einem Bipolartransistor,
FIG 2    den Basisstrom am NPN-Bipolartransistor und

FIG 3    eine Schaltungsanordnung nach FIG 1.

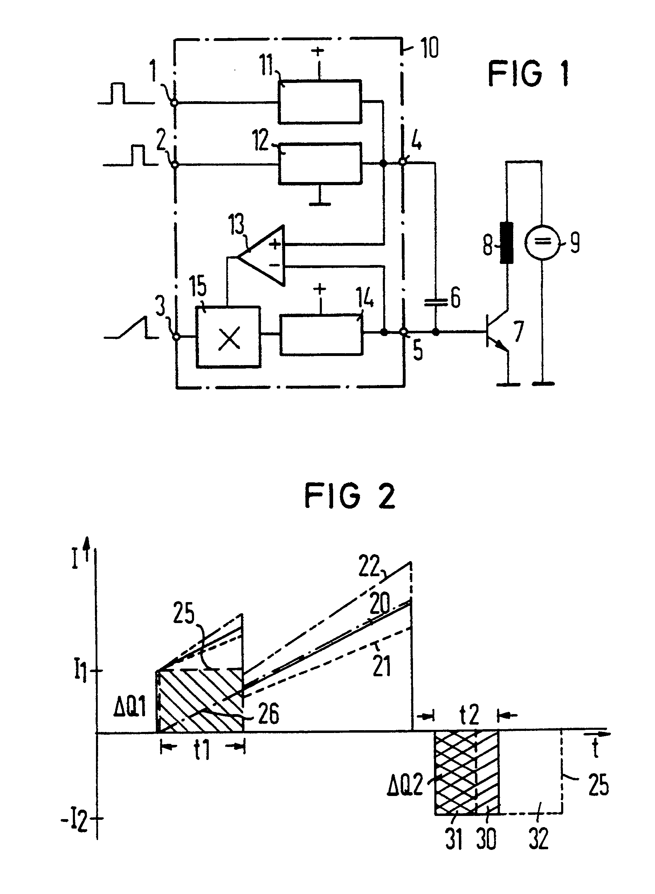

Das in FIG 1 dargestellte Blockschaltbild einer erfindungsgemäßen Schaltungsanordnung zur Durchführung des Verfahrens zur Basisstromregelung zeigt eine Steuereinrichtung 10 mit insgesamt fünf Anschlüssen 1, 2, 3, 4 und 5. Zwischen die Anschlußklemmen 4 und 5 ist ein Koppelkondensator 6 geschaltet. Zugleich ist an den Anschluß 5 die Basisklemme eines NPN-Bipolartransistors 7 geschaltet, dessen Laststrecke mit der Reihenschaltung eines Lastwiderstandes 8 und einer Gleichspannungsquelle 9 verbunden ist. Der Lastwiderstand 8 kann — wie in FIG 1 dargestellt — z.B. eine induktive Last sein. Die Steuereinrichtung 10 weist eine erste steuerbare Stromquelle 11, eine steuerbare Stromsenke 12, einen Differenzverstärker 13, eine zweite steuerbare Stromquelle 14 und einen Multiplizierer 15 auf. Die Eingangsklemme der steuerbaren Stromquelle 11 ist mit der Anschlußklemme 1 der Steuereinrichtung 10 verbunden, während die Ausgangsklemme der steuerbaren Stromquelle 11 an die Anschlußklemme 4 geschaltet ist. Die Stromsenke 12 ist mit ihrer Eingangsklemme an die Anschlußklemme 2 der Steuereinrichtung 10 und mit ihrer Ausgangsklemme auch an die Anschlußklemme 4 geschaltet. Diese Anschlußklemme 4 ist weiterhin an den positiven Eingang des Differenzverstärkers 13 geschaltet. Die Anschlußklemme 5 der Steuereinrichtung 10 ist mit dem negativen Eingang des Differenzverstärkers 13 verbunden. Der Ausgang dieses Differenzverstärkers 13 ist mit einem Eingang des Multiplizierers 15 verbunden, dessen anderer Eingang an die Anschlußklemme 3 der Steuereinrichtung 10 geschaltet ist. Zwischen der Ausgangsklemme dieses Multiplizierers 15 und der Anschlußklemme 5 der Steuereinrichtung 10 ist die zweite steuerbare Stromquelle 14 so geschaltet, daß die Eingangsklemme der zweiten steuerbaren Stromquelle 14 mit dem Ausgang des Multiplizierers 15 und die Ausgangsklemme der steuerbaren Stromquelle 14 mit der Anschlußklemme 5 verbunden ist.

Zur Durchführung unseres erfindungsgemäßen Verfahrens ist es bei dieser Schaltungsanordnung nach FIG 1 vorgesehen, an die Anschlußklemme 1 einen Ansteuerimpuls zum Einschalten und an die Anschlußklemme 2 einen Ansteuerimpuls zum Ausschalten des Schalttransistors anzulegen. Erhält die Anschlußklemme 1 einen Impuls der Zeitdauer $t_1$, so prägt die steuerbare Stromquelle 11 während dieser Zeit $t_1$ einen Strom $I_1$ in die Anschlußklemme 4 ein und der Basisanschluß des Schalttransistors 7 erhält über den in Serie geschalteten Koppelkondensator 6 eine Ladung $\Delta Q_1$. Diese Ladung $\Delta Q_1$ ergibt sich aus dem Produkt der Zeit $t_1$ und dem Strom $I_1$. Die Ladung $\Delta Q_1$ des Koppelkondensators 6 ist so zu wählen, daß der Schalttransistor 7 damit gerade in die quasi-Sättigung getrieben wird. Die Ladung des Koppelkondensators 6 erhöht sich gleichzeitig um $\Delta Q_1$. Zum Abschalten des Schalttransistors 7 liegt an der Anschlußklemme 2 mindestens solange ein Steuerimpuls an, bis der Schalttransistor 7 vollständig sperrt. Das Zeitintervall vom Beginn dieses Steuerimpulses bis zum Sperren des Schalttransistors 7 wird im folgenden mit $t_2$ bezeichnet. Während dieser Zeit $t_2$ entnimmt die Stromsenke 12 über den Anschluß 4 dem Doppelkondensator 6 den Strom $I_2$. Der Anschluß 5 ist während der Zeit $t_2$ stromlos, so daß der Schalttransistor 7 mit der Stromstärke $I_2$ ausgeräumt wird. Die zum Ausräumen notwendige Ladungsmenge ergibt sich aus $\Delta Q_2 = I_2 \times t_2$. Um diese Ladungsmenge $\Delta Q_2$ vermindert sich die Ladung im Koppelkondensator 6.

Die Anschlußklemme 3 ist dazu vorgesehen, ein vorzugsweise dem beabsichtigten Kollektorstromverlauf des Schalttransistors 7 nachgebildetes Steuersignal einzuprägen. Dieser an der Anschlußklemme 3 anliegende Steuersignal wird mit einem der Ausgangsspannung des Differenzverstärkers 13 entsprechenden Wert multipliziert und das Ergebnis der zweiten Stromquelle 14 als Steuersignal zugeführt. Der aus der Stromquelle 14 herausfließende Steuerstrom wird der Basis des Schalttransistors 7 zugeführt, ohne die Ladung des Kondensators 6 zu beeinflußen. Er dient dem Erhalt der Leitfähigkeit des Schalttransistors 7 vom Ende des Ansteuerimpulses an Anschluß 1 bis zum Beginn des Ansteuerimpulses an der Anschlußklemme 2.

Im Zusammenhang mit FIG 2 wird im folgenden das Zusammenwirken der einzelnen Schaltungskomponenten des in FIG 1 dargestellten Blockschaltbildes anhand eines Ausführungsbeispieles näher erläutert :

Bei diesem Ausführungsbeispiel wird als zu schaltende Last eine induktive Last 8 angenommen. An der Anschlußklemme 3 liegt ein z.B. diesem Laststrom nachgebildeter sägezahnförmig verlaufender Strom an. Der Kondensator ist durch eine äußere Beschaltung zu Beginn des Basisstromregelvorganges auf eine Grundladung $Q_0$ aufgeladen. Kurz bevor der Steuerstrom aus der Anschlußklemme 5 zu fließen beginnt oder gleichzeitig mit ihm, wird über einen entsprechenden Ansteuerimpuls an der Anschlußklemme 1 der Bipolartransistor 7 mit der Ladung $\Delta Q_1$ bis in die quasi-Sättigung getrieben. Der Schalttransistor schaltet ein und die Kondensatorladung erhöht sich um $\Delta Q_1$. Durch den über die zweite steuerbare Stromquelle 14 dem Schalttransistor 7 eingeprägten Steuerstrom wird der Zustand der quasi-Sättigung gerade erhalten, falls die Stromamplitude richtig eingestellt ist. Soll der Bipolartransistor 7 ausgeschaltet werden, wird ein entsprechender Ansteuerimpuls an die Anschlußklemme 2 gelegt, wodurch die Stromsenke 12 dem Anschluß 4 die Stromstärke $I_2$ entnimmt. Dies geschieht solange, bis der Bipolartransistor 7 ausschaltet. Damit vermindert sich die Ladung im Kondensator 6 um $\Delta Q_2$. Im abgeschalteten Zustand des Bipolartransistors 7 befindet sich also folgende Ladung im Kondensator 6 :

3

$$Q'_0 = Q_0 + \Delta Q_1 - \Delta Q_2.$$

Eine große Ladung $\Delta Q_2$ deutet auf eine starke Sättigung des Bipolartransistors hin, eine kleine Ladung auf eine Untersättigung. Gleiches gilt für die im Koppelkondensator 6 gespeicherte Ladung, bzw. die am Koppelkondensator 6 anliegende Spannung. Die am Koppelkondensator 6 anliegende Spannung wird über den Differenzverstärker 13 erfaßt. Über den Ausgang dieses Differenzverstärkers 13 ist die Stromamplitude des aus Anschluß 5 herausfließenden Steuerstromes variierbar. So wird z.B. bei einer starken Sättigung des Bipolartransistors 7 die Ausgangsspannung des Differenzverstärkers 13 erniedrigt, bei Untersättigung erhöht. Eine hohe Spannung am Ausgang des Differenzverstärkers 13 deutet daraufhin, daß der Bipolartransistor 7 in Untersättigung betrieben wurde und daß die Stromamplitude zur Aufrechterhaltung der quasi-Sättigung des Bipolartransistors 7 erhöht werden muß, um so eine höhere Sättigung zu erreichen. Bei ausreichend hoher Schaltgeschwindigkeit genügt anstelle einer Amplitudenmodulation auch eine Modulation der Dauer des aus der Stromquelle 14 herausfließenden Steuerstromes.

In FIG 2 ist die jeweilige Ladung $\Delta Q_2$, daß ist also die Ladung, um die sich die Ladung im Koppelkondensator 6 beim Abschalten des Bipolartransistros 7 vermindert, für starke Sättigung 32, Untersättigung 31 und quasi-Sättigung 30, also Optimalbetrieb, dargestellt. Außerdem zeigt FIG 2 unterschiedliche Verläufe des Stromes zur Aufrechterhaltung der quasi-Sättigung des Bipolartransistors 7. Diese Stromverläufe sind mit dem Bezugszeichen 20, 21 und 22 gekennzeichnet. 20 bezeichnet den resultierenden Basisstrom bei quasi-Sättigung, 21 bei Untersättigung und 22 bei Übersättigung. Mit 25 ist der Strom aus dem Anschluß 4 und mit 26 der Strom aus dem Anschluß 5 bezeichnet. Die Bezugszeichen 30, 31 und 32 bezeichnen die Ausräumladungen $\Delta Q_2$ für quasi-Sättigung, Untersättigung und Übersättigung. 25 zeigt den Verlauf des Ausräumstromes $I_2$ bei Übersättigungsbetrieb. Wird der Bipolartransistor 7 z.B. mit einer hohen Stromamplitude — vgl. dazu Kurve 22 — betrieben, so muß zum Ausschalten des Bipolartransistors 7 mehr Ladung — vgl. 32 — aus seiner Basiszone ausgeräumt werden, als bei quasi-Sättigung. Entsprechend dieser langen Speicherzeit wird der Koppelkondensator 6 stark entladen. Die Ladung im Koppelkondensator 6 vermindert sich um die in der FIG 2 mit 32 bezeichnete Ladung. Am Ausgang des Differenzverstärkers 13 liegt danach eine geringere Spannung an. Dies führt zu einer geringeren Stromamplitude für den nächsten Schaltzyklus. Die Stromamplitude wird vorzugsweise solange nachgeregelt, bis die Ladung $\Delta Q_2$ der vorgegebenen Ladung $\Delta Q_1$ entspricht. Damit ist eine optimale Ansteuerung des Bipolartransistors 7 gewährleistet. Eine bevorzugte Weiterbildung der Erfindung sieht vor, daß ein Regelkreis den Basisstrom über mehrere Schaltzyklen sukzessive so einstellt, daß das Basisstrom-Zeit-Integral, also die Ladung $\Delta Q_2$ des Ausräumvorganges, einem vorgegebenen Sollwert $\Delta Q_1$ entspricht.

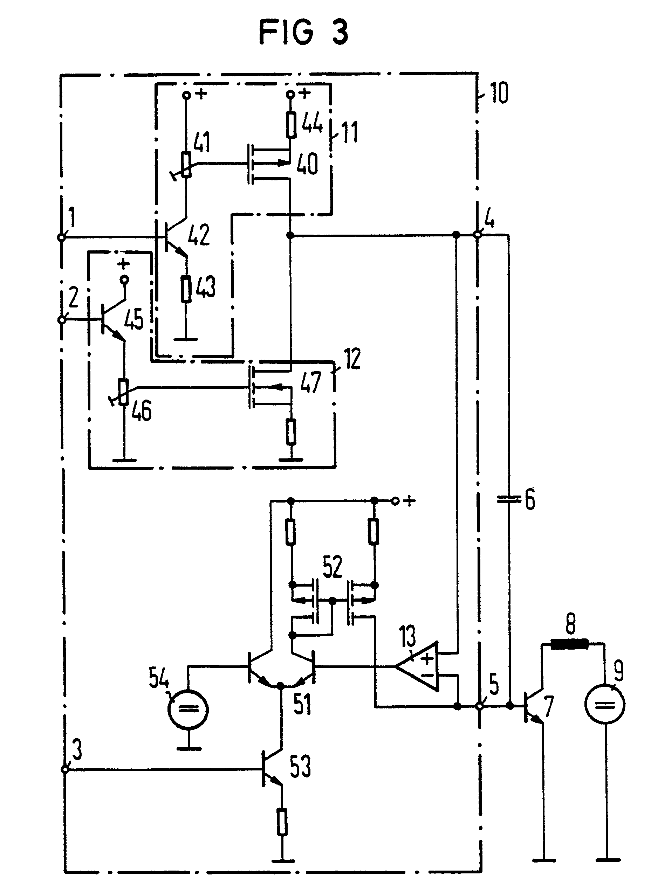

In FIG 3 ist ein Ausführungsbeispiel für das Blockschaltbild nach FIG 1 dargestellt. Gleiche Bezugszeichen wie in FIG 1 stehen für gleiche Schaltelemente. Als erste Stromquelle 11 ist z.B. ein P-Kanal-Anreicherungs-MOSFET 40 vorgesehen, der über einen Spannungsteiler 41 mit dem Kollektoranschluß eines NPN-Transistors 42 verbunden ist. Dieser NPN-Transistor 42 ist in Emitterschaltung mit Stromgegenkopplung über den Widerstand 43 geschaltet. Über den Spannungsteiler 41 kann die im Zusammenhang mit den FIG 1 und 2 bereits erläuterte Ladung $\Delta Q_1$ eingestellt werden. Der Source-Anschluß des MOSFET 40 liegt über einen Widerstand 44 auf positiven Potential, während der Drain-Anschluß des P-Kanal-MOSFET 40 mit der Ausgangsklemme 4 der Steuereinrichtung 10 verbunden ist.

Die steuerbare Stromsenke 12 ist durch einen Emitterfolger 45 mit einstellbarem Spannungsteiler 46 realisiert, dessen Ausgangsklemme mit dem Gate-Anschluß eines N-Kanal-Anreicherungs-MOSFETs 47 verbunden ist. Der P-Kanal-MOSFET 40 und der N-Kanal-MOSFET 47 sind in Gegentaktschaltung zueinander angeordnet. Am Spannungsteiler 46 kann der Ausräumstrom $I_2$ eingestellt werden.

Am Ausgang des Differenzverstärkers 13 ist die Basis des ersten Transistors eines Transistorpaares 51 geschaltet. Die Basis des zweiten Transistors ist mit einer Gleichspannungsquelle 54 verbunden. Das Transistorpaar 51 hat die Funktion eines Multiplizierers. Je nach Spannung zwischen den beiden Basisanschlüssen verteilt sich der am gemeinsamen Emitteranschluß entnommene Strom auf die beiden Kollektorströme. Im Kollektorzweig des ersten Transistors befindet sich die Steuerstrecke eines aus zwei Anreicherungsfeldeffekttransistoren bestehenden Stromspiegels 52, dessen Ausgang mit dem Anschluß 5 verbunden ist. Mit dem gemeinsamen Emitteranschluß des Transistorpaares 51 ist der Kollektoranschluß eines Transistors 53 in Emitterschaltung mit Stromgegenkopplung verbunden. Der Basisanschluß dieses Transistors 53 ist mit dem Anschluß 3 verbunden. Der aus dem Stromspiegel 52 über den Anschluß 5 herausfließende Strom ist damit proportional dem Produkt aus einer von der Spannung am Anschluß 3 und einer von der Differenzspannung zwischen den Anschlüssen 4 und 5 abgeleiteten Größe.

Zur Verbesserung des Schaltverhaltens ist es vorgesehen, den Steuerstrom zum Ansteuern des Bipolartransistors 7 einige Mikrosekunden vor Beginn des Ausräumvorganges, also vor Beginn des Abschaltens des Bipolartransistors 7 abzuschalten. Ist der Kollektorspitzenstrom bekannt und abhängig z.B. von einem Regelsignal in einem Schaltnetzteil, so verbessert eine Nachführung des Größe $\Delta Q_1$ proportional zum Kollektorspitzenstrom das Schaltverhalten über einen weiten Regelbereich.

Eine Nachführung des Ausräumstromes $I_2$ mit der momentan gültigen Steuerstromamplitude verringert die Abschaltverluste über einen großen Lastbereich.

Selbstverständlich kann auch ein PNP-Schalttransistor verwendet werden, wobei die Polaritäten in bekannter Weise geändert werden müssen.

Das erfindungsgemäße Verfahren und die zur Durchführung des Verfahrens vorgeschlagene Schaltungsanordnung eignet sich besonders für die direkte Ansteuerung von Bipolarschalttransistoren durch integrierte Schaltungen in periodisch arbeitenden Systemen. Solche periodisch arbeitenden Systeme können z.B. Schaltnetzteile oder Vorschaltgeräte für Leuchstofflampen sein.

## Patentansprüche

1. Verfahren zur Basisstromregelung eines Schalttransistors, der zum Einschalten mit einem Basisstrom beaufschlagt und dessen Basiszone zum Ausschalten von Ladungsträgern ausgeräumt wird, **dadurch gekennzeichnet,** daß beim Ausschalten des Schalttransistors dessen Basisstrom-Zeit-Integral $\Delta Q_2$ als Maß für die Sättigung des Schalttransistors bestimmt wird, und daß abhängig von der Größe dieses Basisstrom-Zeit-Integrals $\Delta Q_2$ der Basisstrom zum Einschalten des Schalttransistors eingestellt wird.

2. Verfahren nach Anspruch 1, **dadurch gekennzeichnet,** daß ein Regelkreis den Basisstrom über mehrere Schaltzyklen sukzessive so einstellt, daß das Basisstrom-Zeit-Integral $\Delta Q_2$ beim Ausschalten einem vorgegebenen Sollwert $\Delta Q_1$ entspricht.

3. Verfahren nach Anspruch 1 oder 2, **dadurch gekennzeichnet,** daß der Basisstrom zum Einschalten des Schalttransistors aus einem ersten und einem zweiten Anteil gebildet wird, daß der erste Anteil dazu vorgesehen ist, den Schalttransistor mit einer Ladung $\Delta Q_1$ zu beaufschlagen und bis in die quasi-Sättigung zu treiben, und daß der zweite Anteil als Steuerstrom zur Aufrechterhaltung der Leitfähigkeit des Schalttransistors im eingeschalteten Zustand dient.

4. Verfahren nach Anspruch 3, **dadurch gekennzeichnet,** daß der Verlauf des Steuerstromes dem beabsichtigten Kollektorstromverlauf des Schalttransistors nachgebildet ist.

5. Verfahren nach Anspruch 1, 2 oder 3, **dadurch gekennzeichnet,** daß der Ausräumstrom abhängig vom Kollektorstrom eingestellt wird.

6. Verfahren nach einem der Ansprüche 1 bis 5, **dadurch gekennzeichnet,** daß der Steuerstrom einige Mikrosekunden vor Beginn des Ausräumvorganges abgeschaltet wird.

7. Verfahren nach einem der Ansprüche 1 bis 6, **dadurch gekennzeichnet,** daß der Sollwert $\Delta Q_1$ entsprechend dem Kollektorspitzenstrom nachgeführt wird.

8. Schaltungsanordnung zur Durchführung des Verfahrens nach einem der Ansprüche 1 bis 7, **dadurch gekennzeichnet,** daß an die Basisklemme des Schalttransistors (7), in dessen Laststrecke die Reihenschaltung eine Last (8) mit einer Spannungsquelle (9) geschaltet ist, ein Koppelkondensator (6) mit seinem einen Anschluß (5) und eine Basisstromquelle mit ihrer Ausgangsklemme angeschlossen ist, daß eine Steuereinrichtung (10) vorgesehen ist, durch die in den anderen Anschluß (4) des Koppelkondensators (6) Ströme positiver oder negativer Polarität einprägbar sind und durch die der Basisstrom am Ausgang der Basisstromquelle abhängig von der Ladung des Koppelkondensators (6) einstellbar ist.

## Claims

1. Method for regulating the base current of a switching transistor, to which a base current is applied for switching on and whose base region is cleared of charge carriers for switching off, characterised in that upon switching off the switching transistor its base current-time integral $\Delta Q_2$ is determined as a measure of the saturation of the switching transistor, and in that the base current to switch on the switching transistor is adjusted as a function of the magnitude of this base current-time integral $\Delta Q_2$.

2. Method according to Claim 1, characterised in that a regulating circuit successively adjusts the base current over a plurality of switching cycles in such a way that the base current-time integral $\Delta Q_2$ upon switching off corresponds to a prescribed desired value $\Delta Q_1$.

3. Method according to Claim 1 or 2, characterised in that the base current for switching on the switching transistor is formed from a first and a second component, in that the first component is provided in order to

apply a charge $\Delta Q_1$ to the switching transistor and to drive the latter into quasi-saturation, and in that the second component serves as control current for maintaining the conductivity of the switching transistor in the switched-on state.

4. Method according to Claim 3, characterised in that the characteristic of the control current is matched to the intended collector current characteristic of the switching transistor.

5. Method according to Claim 1, 2 or 3, characterised in that the depletion current is adjusted as a function of the collector current.

6. Method according to one of Claims 1 to 5, characterised in that the control current is switched off a few microseconds before the start of the depletion process.

7. Method according to one of Claims 1 to 6, characterised in that the desired value $\Delta Q_1$ is adjusted to follow up the collector peak current.

8. Circuit arrangement for carrying out the method according to one of Claims 1 to 7, characterised in that a coupling capacitor (6) is connected with one terminal (5), and a base current source is connected with its output terminal, to the base terminal of the switching transistor (7), in whose load section the series circuit of a load (8) and a voltage source (9) is connected, and in that a control device (10) is provided, by means of which currents of more positive or more negative polarity can be injected into the other terminal (4) of the coupling capacitor (6), and by means of which the base current at the output of the base current source can be adjusted as a function of the charge on the coupling capacitor (6).

## Revendications

1. Procédé pour régler le courant de base d'un transistor de commutation, qui est chargé par un courant de base pour sa mise à l'état conducteur et dont la zone de base est vidée de porteurs de charges, pour le blocage du transistor, caractérisé par le fait que lors du blocage du transistor de commutation, on détermine l'intégrale dans le temps du courant de base, $\Delta Q_2$, en tant que mesure de la saturation du transistor de commutation et qu'on règle le courant de base pour la mise à l'état conducteur du transistor de commutation en fonction de la valeur de cette intégrale du courant de base dans le temps, $\Delta Q_2$.

2. Procédé suivant la revendication 1, caractérisé par le fait qu'un circuit de réglage règle le courant de base successivement sur plusieurs cycles de commutation de manière que l'intégrale dans le temps du courant de base $\Delta Q_2$ corresponde, lors du blocage, à une valeur de consigne prédéterminée $\Delta Q_1$.

3. Procédé suivant la revendication 1 ou 2, caractérisé par le fait que le courant de base pour la mise à l'état conducteur du transistor de commutation est formée par une première partie et une seconde partie, que la première partie est prévue pour charger le transistor de commutation avec une charge $\Delta Q_1$ et pour l'amener à fonctionner quasiment jusqu'à la saturation et que la seconde partie est utilisée comme courant de commande pour maintenir la conduction du transistor de commutation à l'état conducteur.

4. Procédé suivant la revendication 3, caractérisé par le fait que la variation du courant de commande est simulée à partir de l'allure envisagée du courant de collecteur du transistor de commutation.

5. Procédé suivant la revendication 1, 2 ou 3, caractérisé par le fait que le courant de vidage est réglé en fonction du courant de collecteur.

6. Procédé suivant l'une des revendications 1 à 5, caractérisé par le fait que le courant de commande est interrompu pendant quelques microsecondes pendant le début de l'opération de vidage.

7. Procédé suivant l'une des revendications 1 à 6, caractérisé par le fait que la valeur de consigne $\Delta Q_1$ est asservie de manière à correspondre au courant maximum de collecteur.

8. Montage pour la mise en oeuvre du procédé suivant l'une des revendications 1 à 7, caractérisé par le fait qu'à la borne de base du transistor de commutation (7), dans la section de charge duquel est branché le circuit série formé d'une charge (8) et d'une source de tension (9), sont raccordées une borne (5) d'un condensateur de couplage (6) et la borne de sortie d'une source de courant de base, qu'il est prévu un dispositif de commande (10), au moyen duquel des courants ayant une polarité positive et négative peuvent être injectés dans l'autre borne (4) du condensateur de couplage (6) et au moyen duquel le courant de base présent à la sortie de la source du courant de base peut être réglé en fonction de la charge du condensateur de couplage (6).

FIG 1

FIG 2

# FIG 3